# DEMANDE DE BREVET EUROPEEN

(11) **EP 4 742 856 A2**
(43) Date de publication de la demande: **13.05.2026**
(21) Numéro de dépôt: 26168452.6
(22) Date de dépôt: 05.11.2024
(51) Int. Cl.: H10D 64/27

(54) **PROCÉDÉ DE FABRICATION D'UN CIRCUIT ÉLECTRONIQUE QUANTIQUE AVEC UN PAS DE GRILLE RÉDUIT**

(30) Priorité: 09.11.2023 FR 2312232
(62) Demande divisionnaire de: 24210749.8
(71) Demandeur: Commissariat à l'Energie Atomique et aux Energies Alternatives, 75015 Paris (FR)
(72) Inventeur: NIEBOJEWSKI, Heimanu, 38054 GRENOBLE CEDEX 09 (FR)
(74) Mandataire: Lebkiri, Alexandre

(57) **Abrégé**

Un aspect de l'invention concerne un circuit électronique (1) comprenant sur un substrat :
• des premières électrodes (51) réparties selon un pas constant R :
• des deuxièmes électrodes (52), chacune disposée entre deux premières électrodes voisines,
• des troisièmes électrodes de grille (53), chacune disposée entre une première électrode et une deuxième électrode voisines,

Dans lequel les premières, deuxièmes et troisièmes électrodes sont réparties selon un pas moyen égal à R/4, et dans lequel au moins deux électrodes parmi les premières électrodes ou au moins deux électrodes parmi les deuxièmes électrodes ou au moins deux électrodes de grille parmi les troisièmes électrodes, présentent chacune un contact électrique indépendant l'un de l'autre.

## Description

### DOMAINE TECHNIQUE DE L'INVENTION

Le domaine technique de l'invention est celui de l'électronique quantique et plus particulièrement de la fabrication d'un tel circuit.

### ARRIÈRE-PLAN TECHNOLOGIQUE DE L'INVENTION

La manipulation d'états quantiques, également appelés « qubits » pour « quantum bits » en anglais, offre de nouvelles possibilités dans la manipulation d'information. Il existe plusieurs types de qubits, tels que les qubits de spin pour lesquels l'information est stockée dans l'état quantique d'un spin. Les circuits électroniques quantiques à même de permettre la manipulation de qubits de spin, comprennent des îlots, également appelés boîtes quantiques, capables de stocker des qubits le temps de leur manipulation et de leur mesure.

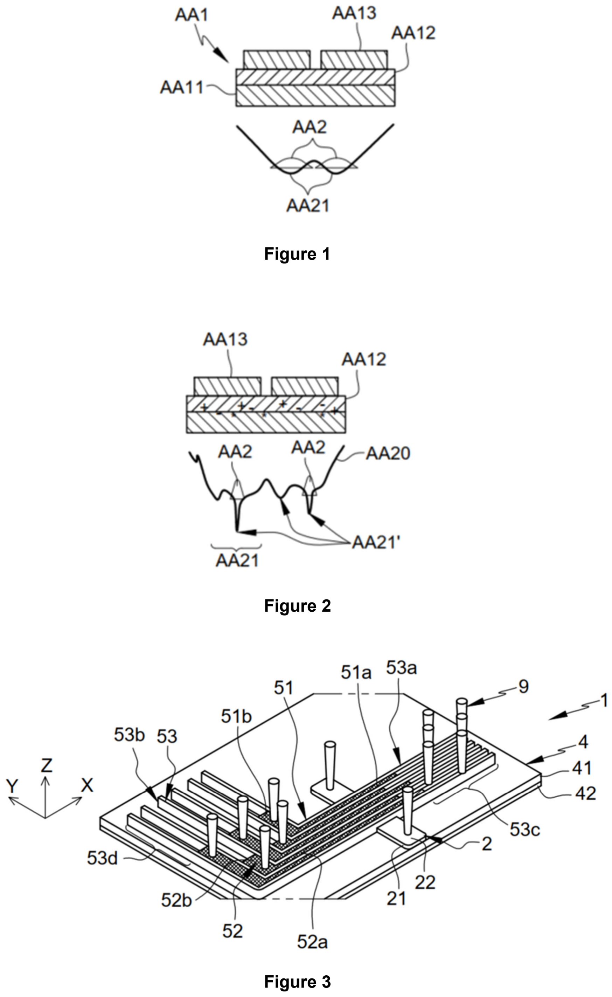

La Fig. 1 représente un exemple simplifié d'une architecture AA1 de circuit électronique telle que couramment mise en œuvre. Selon cette architecture, les boîtes quantiques AA21 sont formées dans une couche semiconductrice AA11 dite couche qubits. Les boîtes AA21 correspondent à des puits formés dans le potentiel électrostatique AA20 de la couche qubits AA11 au moyen d'électrodes AA13 conductrices, dites « électrodes de grille » ou « grilles ». Les grilles AA13 sont disposées sur la couche qubits AA11 et électriquement isolées de cette dernière par une couche diélectrique AA12, dite « oxyde de grille » car fréquemment formée par un oxyde. La modulation du potentiel électrique des grilles AA13 permet de moduler la forme des boîtes quantiques AA21. Lorsque chaque boîte AA21 comprend un qubit A2, ces modulations permettent de manipuler les qubits AA2.

L'intégration de boîtes quantiques AA21 sous forme de circuit électronique doit satisfaire plusieurs exigences. D'une part offrir une haute densité d'intégration afin d'offrir une capacité de calcul conséquente. D'autre part, les procédés de fabrication desdits circuits électroniques quantiques doivent s'assurer d'une faible variabilité des circuits. En effet, l'efficacité du stockage et de la manipulation des qubits AA2 est fortement tributaire de la position des qubits au sein des boîtes quantiques AA21. Toutefois ces dernières peuvent être influencées par leur environnement.

La Fig. 2 considère le circuit de la Fig. 1 dans lequel une distribution de charges électriques AA14 est dispersée dans la couche qubits AA11 et/ou la couche diélectrique AA12. Ces charges électriques AA14 correspondent par exemple à des dopants ou des lacunes dilués au sein de ces couches AA11, AA12. Cette distribution de charges AA14 modifie le potentiel électrostatique AA20 au niveau de la couche qubits AA11 et déforme les boîtes quantiques AA21. Des puits de potentiel parasites AA21' peuvent être formés, piégeant les qubits AA2. La localisation des qubits AA2 devient ainsi erratique au lieu d'être à l'aplomb des grilles AA13. La manipulation des qubits AA2 est rendue plus difficile.

Afin de réduire l'impact des charges électriques AA14 sur la localisation des qubits 2, il est connu de réduire l'espacement entre les grilles voisines AA13. La réduction de l'espacement entre ces grilles AA13 revient à réduire l'intervalle de répartition entre ces grilles AA13, appelé pas ou « pitch » en anglais. Un pitch de grille inférieur à 80 nm, et préférentiellement inférieur à 25 nm, permet de contrer efficacement l'impact de la distribution de charges électriques AA14 sur les boîtes AA21. Toutefois, fabriquer un circuit électronique avec un pitch de grille fortement réduit soulève de nouveaux problèmes.

La fabrication de grilles AA13 présentant un pitch inférieur à 25 nm nécessite par exemple la mise en œuvre d'étapes de lithographie dans l'ultraviolet extrême dit « extrem ultraviolet » en anglais ou encore « EUV ». Ce type de lithographie nécessite des installations coûteuses et complexes. De plus, elle peut donner lieu à un phénomène de dérive lorsque plusieurs étapes de lithographies EUV se succèdent (dite « pitch walking » en anglais).

Un pitch de grille faible complexifie également l'alignement des contacts électriques sur chaque grille. Un mauvais alignement ou un débordement des contacts peut court-circuiter plusieurs grilles entre elles rendant le circuit inutilisable.

Le document US 2019/0140073 A1 décrit un procédé de fabrication d'un dispositif quantique à partir d'un substrat sur lequel s'étendent des premières grilles. Ces premières grilles sont réparties parallèlement les unes aux autres et selon un pitch de grille initial. Des deuxièmes grilles sont formées entre les premières grilles. Les premières et deuxièmes grilles sont ainsi réparties avec un pas réduit, égale à la moitié du pitch de grille initial. Ce procédé permet ainsi de réduire le pitch de grille final du circuit quantique. Toutefois, sauf à mettre en œuvre des étapes de lithographies EUV, il ne permet pas d'atteindre un pitch final suffisamment faible pour améliorer la localisation des qubits.

### RÉSUME DE L'INVENTION

Il existe donc un besoin de fournir un circuit électronique permettant de former des boîtes quantiques de largeur réduite, par exemple inférieur à 80 nm, et ne requérant pas la mise en œuvre d'étapes de lithographie par EUV pour sa fabrication.

L'invention offre un procédé de fabrication d'un circuit électronique permettant d'atteindre un pitch de grille final divisé par quatre par rapport à un pitch de grille initial, par exemple égal au pitch minimum accessible avec un équipement de lithographie de type DUV (pour « Deep UV » en anglais). Il est ainsi envisageable d'atteindre un pitch de grille final inférieur à 80 nm, voire inférieur à 25 nm, avec un équipement DUV permettant classiquement d'obtenir un pitch de grille de 100 nm.

Pour cela, l'invention concerne un procédé de fabrication d'un circuit électronique à partir d'un substrat, comprenant les étapes de :
- former, sur le substrat, des premières électrodes de grille distantes les unes des autres , chaque première électrode de grille présentant une première branche s'étendant parallèlement à une première direction, les premières branches des premières électrodes de grille étant réparties selon un pas constant R, mesuré selon une deuxième direction perpendiculaire à la première direction ;
- former des espaceurs, contre les premières électrodes de grille ;
- former, sur le substrat, des deuxièmes électrodes de grille, chaque deuxième électrode de grille étant disposée entre deux premières électrodes de grille voisines et séparée de chacune d'elles par un des espaceurs, chaque deuxième électrode de grille présentant une première branche s'étendant entre les deux premières branches des premières électrodes de grille voisines ; et
- former, en remplacement des espaceurs, des troisièmes électrodes de grille, chaque troisième électrode de grille étant disposée entre une première électrode de grille et une deuxième électrode de grille voisines, chaque troisième électrode de grille présentant une première branche s'étendant entre une première branche d'une première électrode de grille et une première branche d'une deuxième électrode de grille.

Par « électrode de grille », on entend une piste conductrice ou une électrode conductrice destinées à appliquer un potentiel électrique sur une couche semiconductrice.

Par « branche », on entend une portion sensiblement droite d'une électrode de grille.

Par « voisins », on entend deux objets plus proches voisins. Par exemple, deux premières électrodes de grille voisines sont distantes l'une de l'autre, adjacentes selon la deuxième direction et plus proches voisines.

Par « pas constant », on entend que le pas est constant à 10% près, voire 5% près.

Par « perpendiculaire » et « perpendiculairement », on entend perpendiculaire à 20° près voire 10° près. De la même manière, par « parallèle » et « parallèlement », on entend parallèle à 20° près voire 10° près.

Par « former contre une électrode de grille », on entend former contre les côtés opposés de ladite électrode de grille.

Par « côtés opposés », on entend deux portions d'un flanc, le flanc étant une surface s'étendant perpendiculairement au substrat et délimitant un objet, tel qu'une électrode de grille.

Par « espaceur », on entend une piste électriquement isolante.

Par « contre » ou « s'étendant contre », on entend qu'un objet est en contact direct, sans intermédiaire.

Le procédé ci-dessus permet de former des premières électrodes avec un pas prédéfini, par exemple à la limite de résolution atteignable par un équipement de lithographie DUV. L'insertion des deuxièmes électrodes de grille entre chaque paire de premières électrodes de grille permet d'obtenir des premières et deuxièmes électrodes de grille réparties, selon la deuxième direction, selon un pas moyen de R/2. L'insertion des troisièmes électrodes, en lieu et place des espaceurs, entre chaque paire de première et deuxième électrodes de grille consécutives, permet d'obtenir des premières, deuxièmes et troisièmes électrodes de grilles réparties selon un pas final moyen divisé par 4 par rapport au pas initial. Pour un pas initial de 100 nm, le pas final moyen est d'environ 25 nm. Ce pas permet de former des boîtes quantiques étroites dans la zone active qui soient peu, voire pas, influencées par les charges distribuées dans le substrat ou la zone active.

Par « pas moyen », on entend la moyenne des distances séparant deux électrodes voisines, mesurées selon la deuxième direction, et pour chaque paire d'électrodes voisines (indépendamment de la notion de première, deuxième ou troisième électrode).

Avantageusement, le remplacement des espaceurs par les troisièmes électrodes de grille comprend une gravure sélective des espaceurs par rapport aux premières et deuxièmes électrodes de grille.

Avantageusement, les premières électrodes de grille sont formées à partir d'un premier matériau sacrificiel, tel que du silicium polycristallin ; les deuxièmes électrodes de grille sont formées à partir d'un deuxième matériau conducteur, tel que du nitrure de titane ; et le procédé comprend une étape de remplacement du premier matériau sacrificiel des premières électrodes de grille par le deuxième matériau conducteur.

Avantageusement, les premières électrodes de grille sont formées à partir d'un premier matériau sacrificiel ; les deuxièmes électrodes de grille sont formées à partir d'un deuxième matériau sacrificiel ; et les troisièmes électrodes de grille sont formées à partir d'un troisième matériau conducteur ; et le procédé comprend une étape de remplacement des premier et deuxième matériaux sacrificiels des premières et deuxièmes électrodes de grille par le troisième matériau conducteur.

Avantageusement, chaque première électrode de grille est formée de sorte que la première branche présente une première largeur, mesurée selon la deuxième direction, inférieure ou égale à R/4 ; et les espaceurs sont formés de manière à présenter une deuxième largeur, mesurée selon la deuxième direction et au niveau des premières branches des premières électrodes de grille, inférieure ou égale à R/4.

Avantageusement, chaque troisième électrode de grille est formée de manière à s'étendre entre des première et deuxième électrodes de grille voisines et de manière à présenter au moins une portion, dite « portion libre », s'étendant au-delà desdites première et deuxième électrodes de grille voisines.

Avantageusement, le procédé comprend, après la formation des espaceurs et avant la formation des troisièmes électrodes de grille, une gravure partielle de chaque première électrode de grille depuis une extrémité, la gravure étant réalisée de manière sélective par rapport aux espaceurs de sorte que chaque espaceur présente une portion libre s'étendant au-delà des premières électrodes de grilles, la formation des deuxièmes électrodes de grille étant réalisée de sorte que lesdites portions d'espaceur s'étendent également au-delà des deuxièmes électrodes de grilles et de sorte que lors de la formation des troisièmes électrode de grille, chaque troisième électrode de grille présentent, après remplacement de chaque espaceur, une portion libre s'étendant au-delà des premières et deuxièmes électrodes de grille.

Avantageusement, le procédé comprend, après la formation des troisièmes électrodes de grille, une étape de reprise de contact sur chaque portion libre des troisièmes électrodes de grille s'étendant au-delà des premières et deuxièmes électrodes de grilles.

Avantageusement, la formation des premières électrodes de grille est réalisée de sorte que chacune des premières, deuxièmes et troisièmes électrodes de grille comprenne également une deuxième branche s'étendant perpendiculairement à sa première branche.

Autrement dit, les première et deuxième branches d'une même première électrode sont réalisées simultanément, par exemple par gravure ou dépôt à travers un même masque. Ainsi, les deuxièmes et troisièmes électrodes de grilles qui s'insèrent entre les premières électrodes de grille peuvent également présenter une deuxième portion s'étendant selon la deuxième direction. Les deuxièmes portions peuvent, par leur orientation perpendiculaire aux premières portions (s'étendant selon la première direction), peuvent être réparties librement selon la première direction sans répercussion sur la répartition selon la deuxième direction. Dès lors ces deuxièmes portions peuvent être réparties de manière relativement espacée pour offrir une reprise de contact aisée, réduisant le risque de court-circuit avec les troisièmes électrodes, sans pour autant impacter le pas final au niveau de la zone active.

Par exemple, la formation des deuxièmes branches des premières et deuxièmes électrodes de grille est réalisée de sorte que, pour chacune des premières et deuxièmes électrodes de grille, une largeur de la deuxième branche, mesurée selon la première direction, est strictement supérieure à une largeur de la première branche.

Avantageusement, le procédé comprend une reprise de contact sur la deuxième branche de chaque première électrode de grille et de chaque deuxième électrode de grille.

Selon un développement, les deuxièmes branches des premières électrodes de grille sont réparties selon un pas constant, mesuré selon la première direction, strictement supérieur à 2 × R.

Avantageusement, le procédé comprend, avant la formation de chaque deuxième électrode de grille et/ou de chaque troisième électrode de grille, le dépôt d'une couche diélectrique, dite « oxyde de grille », sur le substrat entre deux premières électrodes de grille voisines, la formation de chaque deuxième électrode de grille et/ou de chaque troisième électrode de grille étant réalisée sur l'oxyde de grille.

Par talon, on entend une couche diélectrique présentant une épaisseur sensiblement constante.

L'invention concerne également un circuit électronique comprenant, sur un substrat :
- des première électrodes de grilles distantes les unes des autres, chaque première électrode de grille présentant une première branche s'étendant parallèlement à une première direction, les premières branches des premières électrodes de grille étant réparties selon un pas constant R, mesuré selon une deuxième direction perpendiculaire à la première direction ;
- des deuxièmes électrodes de grille, chaque deuxième électrode de grille étant disposée entre deux premières électrodes de grille voisines, chaque deuxième électrode de grille présentant une première branche s'étendant entre les deux premières branches des premières électrodes de grille voisines,
le circuit électronique étant remarquable en ce qu'il comprend des troisièmes électrodes de grille, chaque troisième électrode de grille étant disposée entre une première électrode de grille et une deuxième électrode de grille voisines, chaque troisième électrode de grille présentant une première branche s'étendant entre une première branche d'une première électrode de grille et une première branche d'une deuxième électrode de grille, et en ce que les premières, deuxièmes et troisièmes électrodes de grilles sont réparties selon un pas moyen, mesuré selon la deuxième direction, égal à R/4.

Dans un mode de réalisation, au moins deux électrodes de grille parmi les premières électrodes de grille ou au moins deux électrodes de grille parmi les deuxièmes électrodes de grille ou au moins deux électrodes de grille parmi les troisièmes électrodes de grille, présentent chacune un contact électrique indépendant l'un de l'autre.

Il est ainsi possible de polariser les grilles indépendamment les unes des autres.

Avantageusement, les premières, deuxièmes et troisièmes électrodes de grille s'étendent au moins en partie sur une portion du substrat, dite « zone active », configurée pour accueillir des boîtes quantiques.

Avantageusement, les premières électrodes de grille comprennent un premier matériau conducteur et les deuxièmes électrodes de grille comprennent un deuxième matériau conducteur, identique au premier matériau conducteur.

Avantageusement, les troisièmes électrodes de grilles comprennent un troisième matériau conducteur, identique aux matériaux des premières et deuxièmes électrodes de grilles.

Avantageusement, chaque troisième électrode de grille présente une portion, dite « portion libre », s'étendant au-delà des première et deuxième électrodes de grille, le circuit comprenant des contacts électriques, chaque contact électrique étant connecté sur une portion libre d'une troisième électrode de grille s'étendant au-delà des première et deuxième électrodes de grille.

L'invention et ses différentes applications seront mieux comprises à la lecture de la description qui suit et à l'examen des figures qui l'accompagnent.

### BRÈVE DESCRIPTION DES FIGURES

Les figures sont présentées à titre indicatif et nullement limitatif de l'invention. Sauf précision contraire, un même élément apparaissant sur des figures différentes présente une référence unique.
Les [Fig. 1], [Fig. 2] présente des circuits selon un art antérieur.
Les [Fig. 3], [Fig. 4] et [Fig. 5] présentent un premier mode de réalisation d'un circuit électronique selon l'invention.
La [Fig. 6] présente un deuxième mode de réalisation d'un circuit électronique selon l'invention.
La [Fig. 7] présente un troisième mode de réalisation d'un circuit électronique selon l'invention.
Les [Fig. 8], [Fig. 9], [Fig. 10], [Fig. 11], [Fig. 12], [Fig. 13], [Fig. 14], [Fig. 15], [Fig. 16], [Fig. 17], [Fig. 18], [Fig. 19], [Fig. 20], [Fig. 21] présentent des dispositifs intermédiaires pouvant être obtenus lors de différentes étapes ou sous-étapes d'un procédé de fabrication selon l'invention.

### DESCRIPTION DÉTAILLÉE

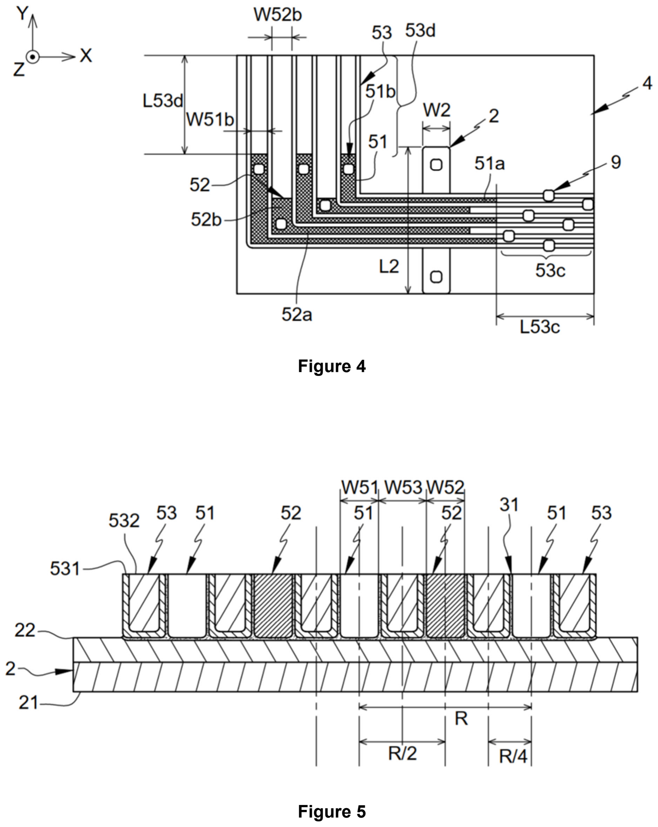

Les figures 3 et 4 présentent schématiquement un premier mode de réalisation d'un circuit électronique 1 selon l'invention. La figure 3 présente une perspective tandis que la figure 4 présente une vue de dessus du circuit 1.

Le circuit électronique 1 comprend un substrat 4 s'étendant dans un plan {X ; Y}. Le substrat 4 comprend une portion 2 dite « zone active ». La zone active 2 est destinée à accueillir des boîtes quantiques et des qubits en son sein. Elle présente une forme de surélévation par rapport au substrat 4, également appelée « mésa ». Le circuit 1 comprend également un réseau d'électrodes conductrices 51, 52, 53 dites électrodes de grille, s'étendant, entre autres, sur la zone active 2. Les électrodes de grille 51, 52, 53 sont agencées pour permettre l'application d'un potentiel électrique sur la zone active 2 de manière à pouvoir moduler le champ électrostatique dans la zone active 2 et former des boîtes quantiques dans celle-ci.

Le circuit 1 permet de former des boîtes quantiques réparties selon une seule direction (en l'occurrence la direction Y). En effet, la zone active 2 présente une forme parallélépipédique avec un très fort rapport d'aspect. Elle présente notamment une épaisseur, mesurée selon une direction Z, très faible, de 5 nm à 30 nm. Elle présente aussi, dans ce mode de réalisation, une largeur W₂, mesurée selon une première direction X, comprise entre 10 nm et 100 nm. Elle présente en revanche une longueur L₂, mesurée selon une deuxième direction Y, supérieure à 100 nm et pouvant atteindre plusieurs micromètres. Cette longueur L₂ dépend, entre autres, du nombre de boîtes quantiques visées, de la dimension et de la répartition des électrodes de grilles 51, 52, 53. De cette manière, les boîtes quantiques formées dans la zone active 2 sont contraintes en largeur (selon X) et en épaisseur (selon Z). En revanche, elles sont distribuées selon la longueur de la zone active 2 (selon Y).

Les électrodes de grille 51, 52, 53, s'étendent au-dessus de la zone active 2, selon la direction X, en chevauchant cette dernière. De cette manière, les électrodes 51, 52, 53 permettent de moduler le champ électrostatique de la zone active 2 selon la direction Y, pour former l'ensemble des boîtes quantiques réparties selon la direction Y.

La zone active 2 comprend une couche mince semiconductrice 21, destinée à recevoir les boîtes quantiques. Cette couche mince 21 peut porter le nom de couche qubits. Dans le mode de réalisation des figures 3 et 4, la couche qubits 21 de la zone active 2 correspond à un prolongement d'une couche épaisse semiconductrice 41 de plus grande dimension du substrat 4. Cet agencement peut être obtenu par gravure de la couche épaisse 41 du substrat 4 à travers un masque de manière à ne conserver que la mésa formant la zone active 2. Alternativement, la couche qubits 21 peut être détourée dans la couche épaisse 41 par une tranchée pratiquée dans la couche épaisse 41 du substrat 4.

La zone active 2 comprend également une couche isolante 22 s'étendant sur la couche qubits 21. Cette couche isolante 22 s'étend entre la couche qubits 21 et les électrodes conductrices 51, 52, 53 formant ainsi une couche dite « oxyde de grille ». L'oxyde de grille 22 peut être formée par oxydation de la surface de la couche qubits 21 ou par dépôt d'un diélectrique sur cette couche 21. Alternativement, l'oxyde de grille peut être d'une autre nature qu'un oxyde, toutefois, par abus de langage, nous la nommerons tout de même « oxyde de grille ». L'oxyde de grille 22 peut présenter une épaisseur, mesurée selon Z, comprise entre 1 nm et 20 nm.

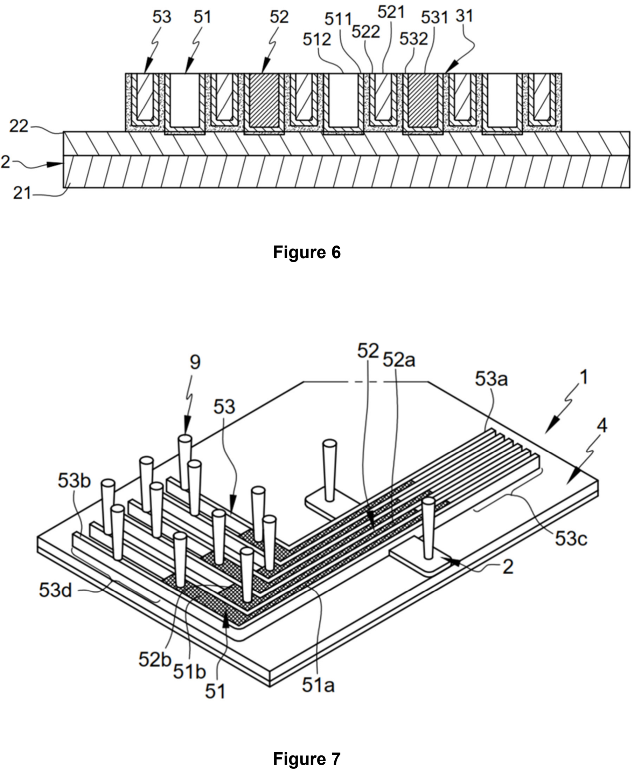

Dans ce mode de réalisation, les électrodes de grille 51, 52, 53 présentent une forme particulière en L. Elles forment ainsi deux branches droites 51a, 52a, 53a, 51b, 52b, 53b consécutives et perpendiculaires l'une à l'autre. Une première branche droite 51a, 52a, 53a s'étend sur la zone active 2, selon la direction X. Une deuxième branche droite 51b, 52b, 53b s'étend à distance de la zone active 2, selon la direction Y. Les électrodes 51, 52, 53 sont agencées côte-à-côte et en appui l'une sur l'autre, uniquement séparées par une couche isolante (discuté plus bas, en référence aux figures 5 et 6). Les premières branches 51a, 52a, 53a s'étendant sur la zone active 2 permettent d'appliquer un champ électrostatique au niveau du zone active 2 et former des boîtes quantiques dans la couche qubits 21. Les deuxièmes branches 51b, 52b, 53b, s'étendant à distance de la zone active 2 permettent de connecter ces électrodes 51, 52, 53.

En l'occurrence, chaque électrode 51, 52, 53 est connectée à un contact 9 électrique. Les contacts 9 sont par exemple des vias conductrices s'étendant perpendiculairement au substrat 4. Ces contacts 9 sont usuellement connectés aux électrodes 51, 52, 53 lors d'une étape dite « de reprise de contact ». Par exemple, un puit est formé à la verticale de chaque électrode 51, 52, 53 et un contact 9 est formé dans ledit puit, en contact direct avec une des électrodes 51, 52, 53.

Des contacts 9 sont également connectés à la zone active 2.

La reprise de contact peut être critique, en partie à cause de l'alignement des puits par rapport aux électrodes 51, 52, 53. Un léger désalignement ou une mauvaise maîtrise du diamètre du puit peut entraîner un chevauchement d'un contact 9 sur deux électrodes 51, 52, 53 voisines. Cette étape de reprise de contact est d'ailleurs rendue plus délicate lorsque le pas entre électrodes est faible, comme c'est le cas dans l'invention.

Pour pallier ce problème, la reprise de contact sur les premières et deuxièmes électrodes 51, 52 est réalisées sur les deuxièmes branches droites 51b, 52b de ces électrodes 51, 52. En effet, les deuxièmes branches droites 51b, 52b, des premières et deuxièmes électrodes 51, 52, orientées selon la deuxième direction Y. Elles peuvent être élargies et/ou écartées sans implication selon la première direction X, c'est-à-dire sur l'agencement des premières branches droites 51a, 51b (afin de conserver un pas optimal au niveau de la zone active 2).

Par exemple, les deuxièmes branches droites 51b des premières électrodes 51 peuvent être réparties selon la première direction X avec un pas constant strictement supérieur à R (R étant le pas constant selon lequel sont réparties les premières branches droites 51a de ces même premières électrodes 51). De manière préférée, lesdites deuxièmes branches droites 51b sont réparties avec un pas constant supérieur à 2 × R. Ainsi, les deuxièmes branches droites 51b, 52b des premières et deuxièmes électrodes 51, 52 peuvent être élargies tout en laissant une place suffisante pour insérer les troisièmes électrodes 53.

De plus, les largeurs W51b, W52b de leurs deuxièmes branches droites 51b, 52b, mesurées selon X, peuvent être choisies suffisamment grandes pour accueillir les contacts 9 sans risque de court-circuit avec une troisième électrode 53 adjacente.

Pour faciliter la reprise de contact sur les troisièmes électrodes 53, sans risque de court-circuit sur les électrodes 51, 52 voisines, chaque troisième électrode 53 s'étend entre une première et deuxième électrodes 51, 52 voisines et au-delà de ces première et deuxième électrodes 51, 52 voisines. Ainsi chaque troisième électrode 53 présentent au moins une portion libre 53c, 53d, formant une ailette sans autre électrode directement en contact avec elle. Ainsi, malgré la faible largeur des troisièmes électrodes 53, elles peuvent être connectée à un contact 9 sans risque de court-circuit.

Dans l'exemple des figures 3 et 4, les troisièmes électrodes 53 présentent deux portions 53c, 53d s'étendant au-delà des premières et deuxièmes électrodes 51, 52. Par exemple, la première branche droite 53a de chaque troisième électrode 53 s'étend selon la première direction X, en chevauchant la zone active 2 et en dépassant les première et deuxième électrodes 51, 52 voisines. Chaque troisième électrode 53 présente alors une première portion libre 53c s'étendant selon la première direction X, depuis une extrémité d'une première ou une deuxième électrode 51, 52. Chaque première portion libre 53c présente alors une longueur L53c, mesurée selon la direction X et depuis une extrémité d'une première ou une deuxième électrode 51, 52, non nulle.

Dans les figures 3 et 4, les premières portions libres 53c sont connectées aux contacts 9.

Dans l'exemple des figures 3 et 4, chaque troisième électrode 53 présente également une deuxième portion libre 53d s'étendant au-delà des premières et deuxièmes électrodes 51, 52. La deuxième branche droite 53b de chaque troisième électrode 53 s'étend selon la deuxième direction Y en dépassant les première et deuxième électrodes 51, 52 voisines. Chaque troisième électrode 53 présente alors une deuxième portion libre 53d s'étendant selon la deuxième direction Y, depuis une extrémité d'une première ou une deuxième électrode 51, 52. Chaque deuxième portion libre 53d présente alors une longueur L53d, mesurée selon la direction Y et depuis une extrémité d'une première ou une deuxième électrode 51, 52, non nulle.

La figure 7 présente un mode de réalisation du circuit 1 dans lequel les deuxièmes portions libres 53d sont connectées aux contacts 9.

La figure 5 présente schématiquement une coupe des électrodes 51, 52, 53 du circuit 1 des figures 3 et 4, cette coupe étant réalisée au niveau de la zone active 2 et selon la direction Y. Cette coupe montre notamment l'agencement des premières branches des électrodes 51a, 52a, 53a au niveau de la zone active 2.

Les électrodes comprennent trois sous-ensembles 51, 52, 53 d'électrodes qui correspondent à des premières électrodes 51, des deuxièmes électrodes 52 et des troisièmes électrodes 53. Les premières électrodes 51 sont au nombre de trois dans ces exemples. Les deuxièmes électrodes 52 sont au nombre de deux. Les troisièmes électrodes 32 sont au nombre de six. Les électrodes 51, 52, 53 s'étendent sur l'oxyde de grille 22. Les électrodes sont disposées côte-à-côte de manière alternée. Elles sont séparées les unes des autres par un film isolant 31 pouvant être un film d'oxyde. Le film isolant présente par exemple une épaisseur comprise entre 1 nm et 5 nm.

Dans ce mode de réalisation, les premières et deuxièmes électrodes 51, 52 sont en silicium polycristallin. Les troisièmes électrodes 53 comprennent une couche en métal 531, par exemple en Ti/TiN, tapissant la cavité dans laquelle se trouve l'électrode 53, et un matériau conducteur 532, par exemple en W, remplissant la cavité tapissée. Lorsque les premières et deuxièmes électrodes 51, 52 sont réalisées à partir du même matériau, elles peuvent être utilisées indifféremment pour former les boîtes quantiques dans la zone active 2.

Alternativement, les premières, deuxièmes et troisièmes électrodes 51, 52, 53 sont réalisées à partir du même matériau. Toutes les électrodes de grilles (51, 52, 53) peuvent être utilisées indifféremment pour former les boîtes quantiques dans la zone active 2.

Les premières, deuxièmes et troisièmes électrodes 51, 52, 53 présentent chacune, au niveau de la zone active 2, une largeur W51, W52, W53 comprise entre 20 nm et 80 nm. Leur agencement côte-à-côte est réalisé de manière périodique. Les premières électrodes 51 sont agencées selon un pas R (également appelé période ou « pitch » en anglais), qui, mesurée selon la direction Y, est préférentiellement inférieur ou égal à 80 nm. Une deuxième électrode 52 et deux troisièmes électrodes 53 sont insérées entre deux premières électrodes 51 voisines. L'agencement final résultat présente un pas R/4. Le pas final R/4 permet de former des boîtes quantiques dans la couche qubits 21 présentant une dimension selon Y qui est réduite, par exemple de l'ordre de 20 nm. Rappelons qu'à cette longueur, les charges électrostatiques distribuées dans la couche qubits 21 ne modifient plus significativement la forme des boîtes quantiques et donc la localisation des qubits dans les boîtes. Ce circuit 1 offre donc une meilleure localisation des qubits dans la couche qubits 21. Il offre donc une meilleure robustesse et/ou une meilleure reproductibilité quant aux opérations qui peuvent être réalisées sur les qubits.

La figure 6 présente schématiquement une variante des électrodes 51, 52, 53 représentées sur la figure 5. Cette variante est matérialisée suivant le même plan de coupe que la figure 6, au niveau de la zone active 2.

À la différence du mode de réalisation de la figure 5, les premières, deuxièmes et troisièmes électrodes 51, 52, 53 présentent chacune une couche en métal 511, 521, 531, par exemple en Ti/TiN, tapissant la cavité accueillant chaque électrode 51, 52, 53, et un matériau conducteur 512, 522, 523, par exemple en W, remplissant la cavité tapissée.

Le film isolant 31 séparant les électrode 51, 52, 53 présente également des différences en ce qu'il présente une épaisseur plus importante à la verticale des troisièmes électrodes 53. Les troisièmes électrodes 51, 53 présentent donc une distance par rapport à la couche qubits 21 qui est supérieure celle des premières et deuxièmes électrodes 51, 52. Ceci peut résulter du mode de fabrication des troisièmes électrodes 53 selon lequel les cavités destinées à accueillir les troisièmes électrodes 53 peuvent d'abord être tapissées du film 31, par exemple en oxyde, avant d'être tapissées à leur tour par une couche métallique en Ti/TiN et remplies par du W. Il peut également résulter de ce mode de fabrication que les troisièmes électrodes 53 présentent une largeur W53 inférieure à la largeur W51, W52 des premières ou deuxièmes électrodes 51, 52. Toutefois, cette réduction de largeur W53 des troisièmes électrodes n'impact pas le pas selon lequel sont réparties les électrodes 51, 52, 53.

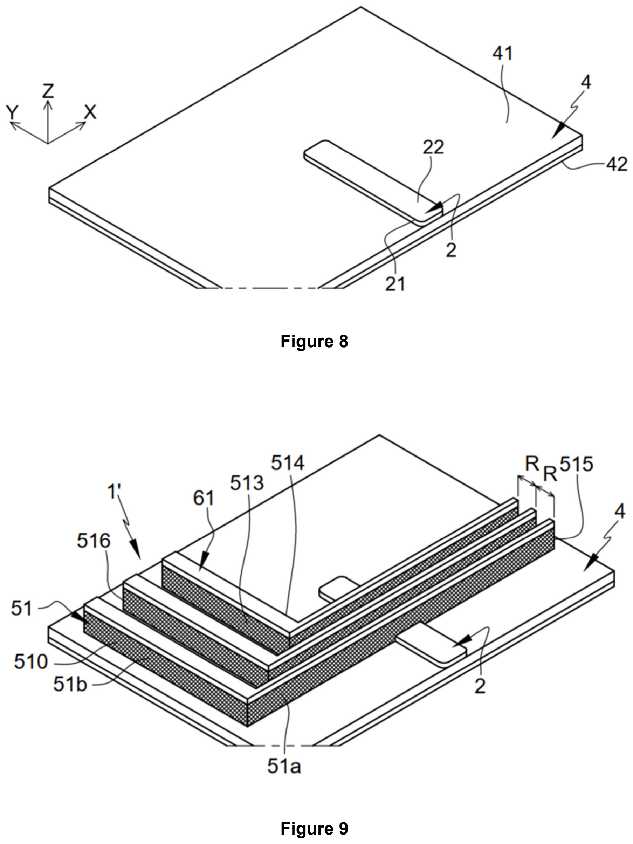

Les figures 8 à 21 présentent schématiquement différentes étapes d'un procédé de fabrication d'un circuit 1 tel que présenté dans les différents modes de réalisation des figures 3 à 7.

La figure 9 présente le résultat d'une première étape du procédé consistant en la formation des premières électrodes de grilles 51. Cette étape peut être précédée d'une étape préliminaire de définition de la zone active 2, telle qu'illustrée par la figure 8. Cette étape est réalisée à partir d'un substrat semiconducteur 4. Le substrat semiconducteur 4 est un substrat massif, par exemple en silicium, ou un substrat de type « SOI » (pour « Semiconductor On Insulator » en anglais, c'est-à-dire « semiconducteur sur isolant »). Dans l'exemple de la figure 8, il s'agit d'un substrat 4 de type SOI avec une couche épaisse semiconductrice 41 en silicium s'étendant sur une couche isolante 42 enterrée, en oxyde de silicium. La zone active 2 est formée par gravure de la couche épaisse 41 à travers un masque. Cette gravure permet de délimiter la couche qubits 21. La gravure est par exemple réalisée sur une épaisseur comprise entre 5 nm et 30 nm. L'oxyde de grille 22 peut être déposé ensuite sur la couche qubits 21 de manière à former la zone active 2.

Comme évoqué précédemment, la délimitation de la zone active 2 peut être réalisée par gravure d'une tranchée dans la couche épaisse 41 plutôt que le retrait total de la partie du substrat 4 qui entoure la zone active 2.

La figure 9 présente le résultat de l'étape visant à former les premières électrodes 51. Les premières électrodes 51 s'étendent sur la zone active 2. Le précurseur 1' de circuit tel qu'illustré comprend notamment trois premières électrodes 51. Chaque première électrode 51 s'étend en partie sur le substrat 4 et en partie sur la zone active 2. Elles présentent chacune deux branches droites 51a et 51b, consécutives et agencées perpendiculairement l'une à l'autre. Une première branche droite 51a s'étend en partie sur la zone active 2, sensiblement perpendiculairement à une arête de cette dernière, et une deuxième branche droite 51b s'étend sensiblement perpendiculairement à la première branche droite 51a.

Les premières électrodes 51 sont distantes, c'est-à-dire sans contact direct entre elles. Dans le mode avantageux présenté dans la figure 9, elles sont également agencées parallèlement par partie les unes par rapport aux autres. Par agencées parallèlement par partie, on entend que les premières branches droites 51a sont parallèles les unes aux autres et que les deuxièmes branches droites 51b sont parallèles les unes aux autres. Selon une autre façon de le formuler, une première électrode 51 est l'image d'une autre première électrode 51 par translation.

La formation des premières électrodes 51 peut être réalisée par dépôt d'une couche d'un premier matériau, recouvrant le substrat 4 et la zone active 2. La couche de premier matériau est gravée à travers un premier masque dur 61 déposé sur le premier matériau. Les parties de premier matériau s'étendant sous le premier masque dur 61 forment les premières électrodes 51. Préférentiellement, le dépôt du premier masque dur 61 est précédé d'un polissage mécanico-chimique (dit « CMP » pour « Chemical and Mechanical Polishing » en anglais) de sorte que le premier matériau présente une surface plane.

Le premier matériau peut être un matériau conducteur, si les électrodes 51 ne sont pas retirées par la suite. Il s'agit par exemple de silicium polycristallin. Il peut également s'agir d'un matériau sacrificiel si les premières électrodes 51 se voient être retirées pour être redéposées. Dans ces deux cas, le premier matériau est choisi pour sa vitesse de gravure, élevée par rapport à celle du masque dur 61. Le masque dur 61 est par exemple un oxyde de silicium SiO₂ ou un nitrure de silicium SiN. La gravure anisotrope peut être réalisée par gravure dite « sèche », c'est-à-dire au moyen d'un plasma, par exemple d'argon.

La photolithographie du premier masque dur 61 sur la couche de premier matériau est réalisée en considérant un pas R atteignable par un équipement de photolithographie. Il s'agit préférentiellement de la résolution maximale atteignable par ledit équipement, c'est-à-dire le pas le plus petit atteignable. Dans le cas d'un équipement opérant dans le spectre ultraviolet profond (dit « DUV » pour « Deep UV » en anglais), le pas R est par exemple égal à 80 nm. Ce pas R permet ainsi de former des première électrodes 51 qui, lorsqu'elles sont au plus près les unes des autres (par exemple au niveau de la zone active 2), sont réparties selon ce pas R.

Les premières électrodes 51 sont formées avec une largeur W51a au niveau de leur premières branches droites 51a qui soit inférieure à R/3 et préférentiellement inférieure ou égale à R/4. Le pas des premières électrodes 51 au niveau de leurs premières branches droites 51a permet de définir le pas final R/4 des électrodes 51, 52, 53 du circuit final 1 au niveau de la zone active 2 (et donc de la couche qubits 21). En travaillant au maximum de résolution, on garantit un pas final R/4 soit minimal. On obtient ainsi des boîtes quantiques étroites et peu, voire pas, déformées par les charges électrostatiques dispersées dans la couche qubits 21.

Les premières électrodes 51 présentent chacune un flanc 510 qui est une surface latérale délimitant chaque électrode 51. Ces flancs 510 sont formées lors de la gravure anisotrope du premier matériau et sont donc orientés selon la direction de la gravure anisotrope. Cette gravure est préférentiellement réalisée avec un angle par rapport au substrat qui soit sensiblement perpendiculaire. Chaque flanc 510 présente deux portions 513, 514 opposées l'une à l'autre, autrement dit deux surfaces opposées l'une à l'autre, formant des côtés opposés.

Par convention, une première électrode 51 a un seul flanc 510 qui délimite entièrement ladite électrode 51. En d'autres termes, le flanc 510 fait tout le tour de l'électrode 51. Les côtés opposés 513, 514 joignent les extrémités 515, 516 des électrodes 51.

Les premières électrodes 51 sont avantageusement formées de manière à présenter une largeur W51b au niveau de leurs deuxièmes branches droites 51b qui soit plus large que la largeur W51a des premières branches droites 51a. En effet, cet élargissement permet d'offrir une large surface pour une reprise de contact.

Cet élargissement des deuxièmes branches droites 51b par rapport aux premières branches droites 51a est rendu possible grâce à l'orientation substantiellement perpendiculaire des deux branches droites 51a, 51b. Ainsi, la largeur W51b des deuxièmes branches droites 51b, mesurées selon la direction X, peut être augmentée sans pour autant augmenter la largeur W51a des premières branches droites 51a selon la direction Y.

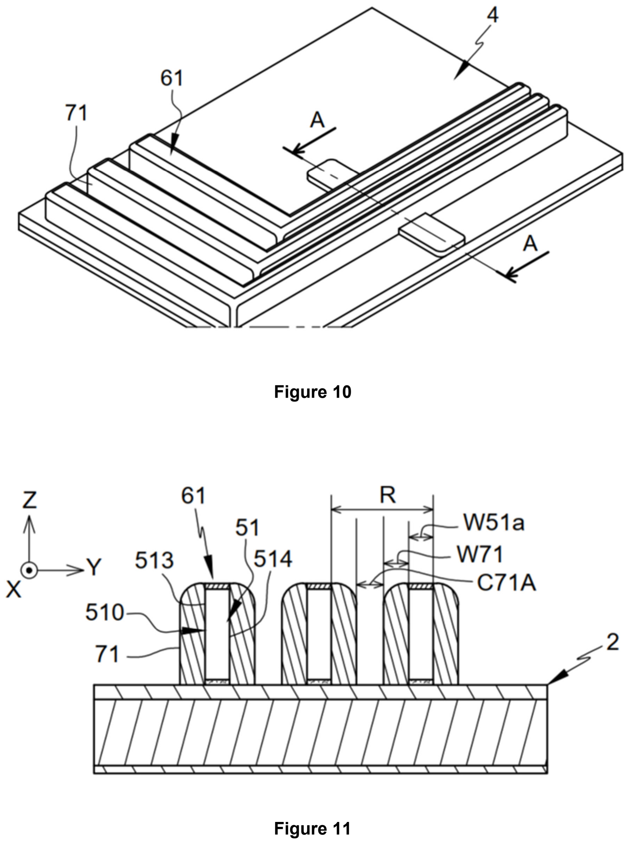

Les figures 10 et 11 présentent une étape de formation de couches en matériau diélectrique 71, dites « espaceurs », s'étendant contre les côtés opposés 513, 514 des premières électrodes 51. La figure 11 présente une coupe de la figure 10 selon le plan A-A, perpendiculaire au premières branches 51a des premières électrodes 51.

Pour obtenir les espaceurs 71, une couche en matériau diélectrique est par exemple déposée de manière conforme sur les premières électrodes 51 et notamment sur les flancs 510 de ces électrodes 51. Une gravure anisotrope est ensuite réalisée pour délimiter les espaceurs 71. La gravure anisotrope est réalisée avec une direction sensiblement parallèle aux flancs 510. Elle est arrêtée lorsque l'oxyde de grille 22 est atteint. Grâce au dépôt conforme et à la gravure anisotrope, il reste une couche de matériau diélectrique 71 s'étendant contre chaque côté opposé 513, 514. Puisque la gravure est arrêtée lorsque l'oxyde de grille 22 est atteint, les espaceurs 71 s'étendant sur des électrodes 51 adjacentes sont distincts et distants les uns des autres.

Chaque espaceur 71 présente une largeur W71 (mesurée depuis le côté opposé 513, 514 sur lequel il est en contact et perpendiculairement à ce côté) qui est préférentiellement constante quel que soit la branche 51a, 51b considérée de l'électrode 51. Cette épaisseur W71 peut toutefois être plus important au niveau des deuxième branches 51b lorsque celles-ci sont suffisamment espacées. L'épaisseur de la couche de matériau diélectrique déposée de manière conforme définit la largeur W71 des espaceurs 71.

L'espacement C71a entre deux espaceurs 71 adjacents, au niveau des premières branches 51a (en considérant qu'elles sont réparties selon le pas R), est égal à C71a = R - 2 W71 - W51a.

Avantageusement, l'épaisseur de la couche de matériau diélectrique déposée de manière conforme pour former les espaceurs est inférieure à R/3. De cette manière, les espaceurs 71 présentent, après formation, des après l'étape de gravure, l'espacement C71a permet l'insertion des deuxièmes électrodes 52. Idéalement, l'épaisseur de la couche de matériau diélectrique est inférieure ou égale à R/4 de sorte que les espaceurs 71 présentent une épaisseur W71 inférieure ou égale à R/4. Les deuxièmes électrodes 52 présentent ainsi, au niveau des premières branches 51a des premières électrodes 51, une épaisseur W52a supérieure ou égale à R/4.

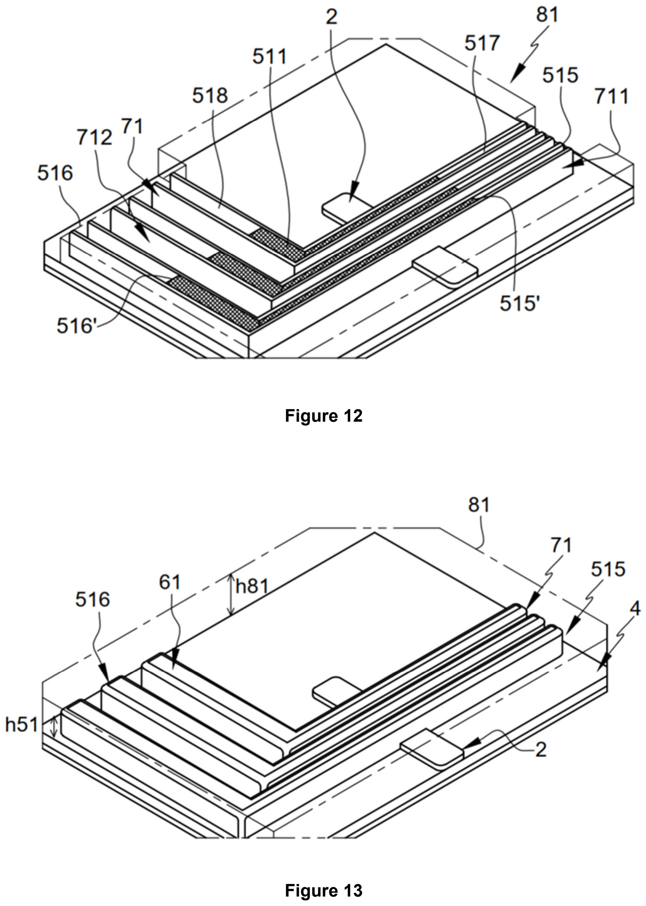

La figure 12 présente l'issue d'une étape de gravure partielle des premières électrodes 51 depuis chacune de leurs extrémités 515, 516. La gravure est réalisée selon une direction parallèle au substrat 4 de manière à retirer des tronçons 517, 518 s'étendant depuis les extrémités 515, 516 des électrodes 51. Les premières électrodes 51 présentent, après gravure, de nouvelles extrémités 515', 516'. La gravure partielle est réalisée de manière sélective par rapport aux espaceurs 71. De la sorte, chaque espaceur 71 présente deux portions 711, 712, libérées de la première électrode 51 sur laquelle elle prenait appui, forme une ailette.

Dans une étape ultérieure, les espaceurs 71 sont remplacés par des électrodes conductrices et en particulier les troisièmes électrodes 53 telles qu'illustrées dans les figures 3 à 7. Les ailettes 711, 712 libérées par la gravure forment les portions libres 53c, 53d des troisièmes électrodes de grille 53. Pour rappel, ces portions libres 53c, 53d sont connectées à des contacts 9 lors d'une étape ultérieure de reprise de contact. La figure 12 montre une gravure réalisée depuis les deux extrémités 515, 516 des premières électrodes 51. Toutefois une gravure réalisée depuis une seule de ces extrémités 515 ou 516 peut suffire pour former les portions libres 53c ou 53d des troisièmes électrodes 53. Il est donc avantageux que la gravure soit réalisée de sorte que la longueur d'un des tronçons 517, 518 permette une reprise de contact aisée au niveau des portions libres 53c, 53d. La longueur du tronçon 517, 518 dépend du nombre de contacts 9 à positionner et du nombre de premières d'électrodes de grille 51. Par exemple pour trois (3) premières électrodes de grilles 51, six (6) contacts 9 peuvent être nécessaires (si les contacts 9 sont positionnées du même côté). Le tronçon 517, 518 retiré peut présenter une longueur d'au moins 300 nm.

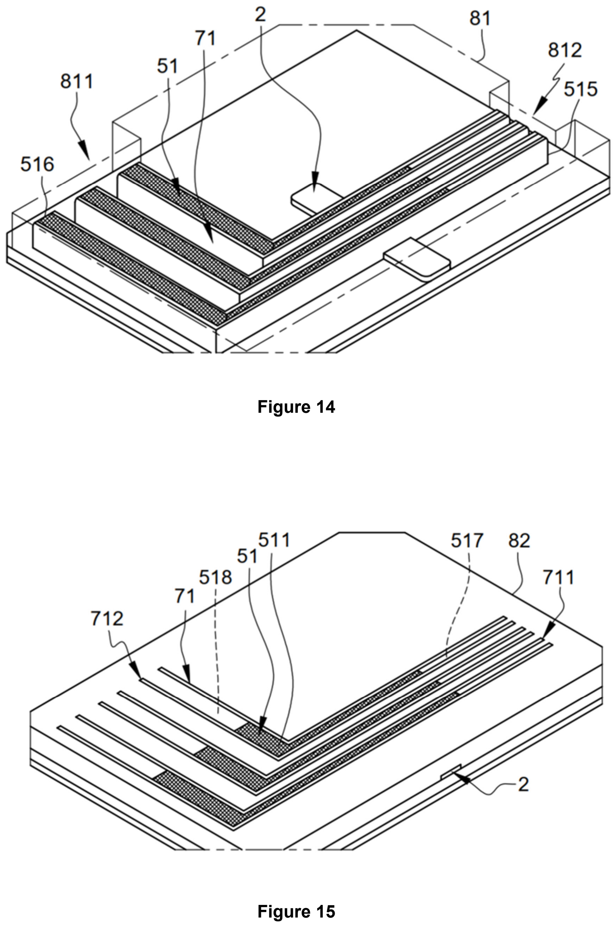

Les figures 13 et 14 présentent deux sous-étapes pour réaliser la gravure partielle des premières électrodes 51. La gravure est notamment réalisée à partir du dispositif illustré aux figures 10 et 11, pour lequel le flanc 510 de chaque première électrode 51 est entourée continument par un espaceur 71, même au niveau de deux extrémités 515, 516. Ainsi, une première sous-étape consiste à dégager au moins une extrémité 515, 516 des premières électrodes 51, par exemple en sectionnant une des extrémités 515, 516. Par extrémité, on entend une portion du flanc 510 qui se trouve par exemple à un apex de l'électrode 51.

Afin de mettre à nu les extrémités 515, 516, les premières électrodes 51, entourées de leurs espaceurs 71, sont recouvertes d'une première couche diélectrique 81, dite couche d'encapsulation ou « couche PMD », pour « pre-metal dielectric » en anglais. Il s'agit par exemple d'une couche en SiO₂ pouvant être obtenue par dépôt plasma. La couche PMD 81 recouvre complètement chaque électrode 51, chaque masque dur 61 et chaque espaceur 71. Un planarisation mécanico-chimique (dite « CMP » pour « chemical and mecahnical planarisation ») peut être réalisée tout en veillant à ce que l'épaisseur h81 de la première couche PMD 81 reste suffisante pour permettre le recouvrement des éléments précités. Une épaisseur h81 de la couche PMD 81 de 1,5 fois la hauteur h51 des premières électrodes 51 est par exemple suffisante.

Une tranchée 811, 812 est réalisée à partir de la surface de la couche PMD 81 et au niveau de chaque extrémité 515, 516 des électrodes 51, afin de libérer ces dernières. Dans le cas d'espèce, deux tranchées 811, 812 sont réalisées, chacune étant disposée à la verticale d'une extrémité 515, 516 d'une électrode 51. Autrement dit, les extrémités 515, 516 de chaque première électrode 51 sont disposées dans le volume qui est retiré pour former les tranchées 811, 812. Les tranchées 811, 812 peuvent être réalisées par gravure anisotrope, par exemple à travers un masque, et stoppées au niveau du substrat 4. Lors de la gravure des tranchées 811, 812, les extrémités 515, 516 de chaque électrode 51 sont alors également gravées. Les portions d'espaceur 71 qui recouvrent les extrémités 515, 516 des électrodes 51 sont alors également gravées, autrement dit retirées, libérant ainsi les extrémités des électrodes 51. Une partie, préférentiellement petite, des électrodes 51 peut également être retirée lors de la gravure des tranchées 811, 812. Les extrémités 515, 516 peuvent alors être légèrement reculées et positionnées à l'aplomb des parois délimitant les tranchées 811, 812.

Les extrémités 811, 812 libres des premières électrodes 51 mettent à nu le premier matériau de chaque électrode 51 de sorte qu'il puisse être retiré.

La figure 12 montre le résultat obtenu lorsque les tronçons extrémaux 517, 518 (s'étendant depuis les extrémités 515, 516) sont retirés à partir du dispositif de la figure 14. Le retrait est par exemple réalisé par gravure isotrope des électrodes 51 grâce aux tranchées 811, 812 qui permettent d'exposer les extrémités des électrodes 51 à une solution de gravure. Ainsi, la gravure est réalisée parallèlement à la surface du substrat 4, en grignotant les électrodes 51 depuis leurs extrémités 515, 516 et en direction de leur centre. La durée et la vitesse de gravure déterminent la longueur du tronçon qui est retiré. Elle détermine également, de manière complémentaire, la longueur des portions libres 53c, 53d.

Ladite solution est par exemple du tetramethylammonium hydroxyde, également connu comme « TMAH ». La solution de gravure est avantageusement choisie pour permettre une gravure sélective par rapport au matériau de l'espaceur 71 et préférentiellement au masque dur 61.

Il est toutefois préférable que la gravure des tronçons extrémaux 517, 518 n'atteigne pas la zone active 2. Il est d'ailleurs préférable que les parties restantes des premières électrodes 51 s'étendent au-delà de la zone active 2 pour ne pas induire d'effet de bord au niveau de la zone active 2.

La gravure anisotrope des premières électrodes 51 réalisée depuis une extrémité 515, 516 permet de contrôler simplement la longueur du tronçon qui est retiré. Il suffit d'ajuster la vitesse de gravure et le temps de gravure, qui sont des paramètres aisément contrôlables. La gravure anisotrope depuis une extrémité permet également de réduire la survenue de problèmes d'alignement. En effet, le retrait des tronçons réalisé par gravure anisotrope perpendiculaire au substrat nécessite une étape d'alignement d'un masque par rapport aux électrodes et aux espaceurs, ce qui induit inévitablement une erreur d'alignement. La longueur des ailettes des troisièmes électrodes pourrait alors être fortement impactée et engendrer des problèmes ultérieurs de connexion lors d'une étape de reprise de contact. Le contrôle de la longueur des tronçons offert par l'invention permet de se prémunir de ce genre de problème.

La figure 15 présente le dispositif de la figure 12 dans lequel les tronçons extrémaux 517, 518, après leur retrait, ont laissé place à un oxyde de type PMD. L'oxyde PMD permet de maintenir les ailettes 711, 712 des espaceurs 71 pour les étapes ultérieures de fabrication.

Cet oxyde PMD est par exemple déposé après retrait partiel de la première couche PMD 81. Le retrait partiel est par exemple réalisé par CMP avec arrêt au niveau du masque dur 61 ou du premier matériau des premières électrodes 51. Une deuxième couche PMD 82 est déposée sur le dispositif de manière à remplir intégralement la place laissée par les tronçons extrémaux 517, 518 retirés. Ce dépôt est par exemple réalisé de manière conforme. Le dispositif de la figure 15 est présenté après une nouvelle planarisation par CMP pour mettre à jour les espaceurs 71 et les premières électrodes 51 partiellement gravées.

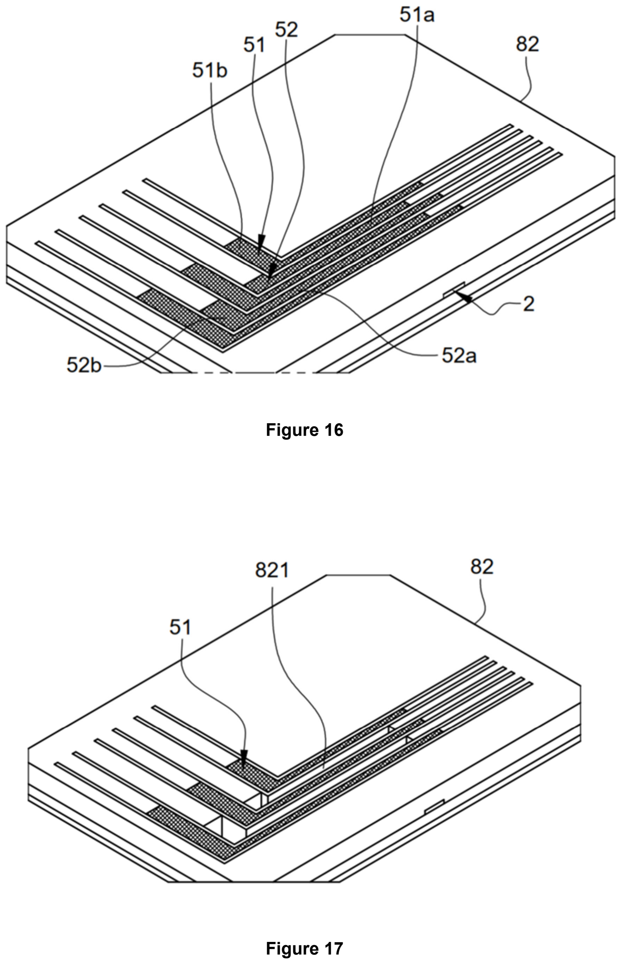

Le dispositif de la figure 16 comprend les deuxièmes électrodes 52 telles que présentées dans les figures 3 à 7. À la différence du dispositif de la figure 15, les deuxièmes électrodes 52 sont disposées entre chaque paire d'espaceurs 71 adjacents.

Les premières et deuxièmes électrodes 51, 52 sont agencées selon un pas R/2, soit la moitié du pas R initial. Ceci est due grâce à l'insertion des électrodes 52 entre les espaceurs 71.

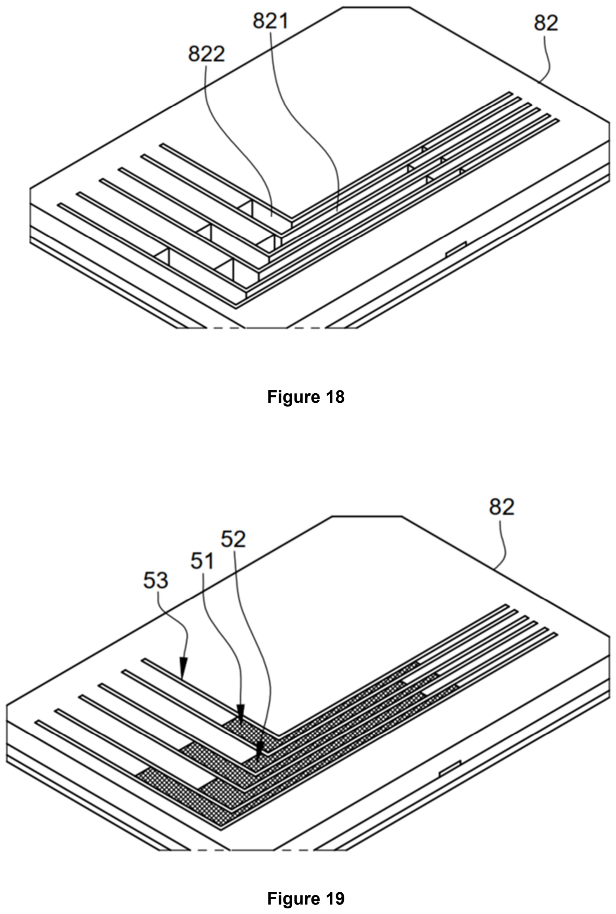

Les figures 17 et 18 présentent deux dispositifs intermédiaires pouvant être obtenus lors d'une première mise en œuvre de sous-étapes permettant de réaliser les premières et deuxièmes électrodes 51, 52 définitives telles qu'illustrées sur la figure 16. Ces deux sous-étapes prennent en entrée le dispositif de la figure 15.

Selon le premier mode de mise en œuvre des sous-étapes pour former les deuxièmes électrodes 52, des premières tranchées 821 sont d'abord formées entre des paires d'espaceurs 71 adjacents ; puis les premières électrodes 51 sont retirées laissant libres des deuxièmes tranchées 822 ; enfin les premières et deuxièmes tranchées 821, 822 sont remplies par un matériau conducteur afin de former les premières et deuxièmes électrodes 51, 52. Le remplissage par le matériau conducteur peut être précédé d'un dépôt de film conducteur, par exemple en Ti/TiN, sur les parois des premières et deuxièmes tranchées 821, 822. Le matériau conducteur, par exemple en W, peut ensuite être déposé pour remplir les tranchées 821, 822.

Lorsque les matériaux des premières et deuxièmes électrodes (51, 52) sont identiques, cela rend les électrodes interchangeables vis-à-vis des boîtes quantiques dans la couche qubit.

Le deuxième mode de mise en œuvre des sous-étapes pour former les deuxièmes électrodes 52 peut être choisi lorsque les premières électrodes 51 sont formées à partir d'un matériau conducteur tel que le silicium polycristallin. À la différence du premier mode de mise en œuvre, il n'est pas utile de retirer les premières électrodes 51. Elles peuvent être conservées. Ainsi, il est uniquement nécessaire de former les premières tranchées 821 entre des espaceurs 71 adjacents ; puis remplir ces premières tranchées 821 avec un matériau conducteur ou une structure de grille pour former les deuxièmes électrodes 52.

La figure 17 montre les premières tranchées 821 pouvant être creusées dans la deuxième couche PMD 82, par exemple suivant la première mise en œuvre des sous-étapes précitées. Ces premières tranchées 821 s'étendant entre les premières électrodes 51, et en particulier entre les espaceurs 71. Les premières tranchées 821 s'étendent au moins sur la zone active 2 et entre les deuxièmes branches 51b des premières électrodes 51.

En pratique, ces premières tranchées 821 peuvent être réalisées par gravure sélective de la deuxième couche de PMD 82 à travers un masque dur. La gravure est réalisée sélectivement par rapport aux espaceurs 71 et au premier matériau des premières électrodes 51. Dans le cas de la figure 17, un masque (non montré) présentant une ouverture rectangulaire est disposé sur les premières électrodes 51. L'ouverture du masque est ajustée pour être à la verticale d'une partie au moins des deux branches 51a, 51b de chaque première électrode 51 et en particulier de son tronçon central 511. L'ouverture du masque est également avantageusement disposée à la verticale du zone active 2. En d'autres termes, la projection de l'ouverture du masque sur le substrat 4 chevauche la zone active 2. Ainsi, les deuxièmes électrodes 52 qui seront réalisées s'étendront sur la zone active 2, voire au-delà de la zone active 2 pour réduire les effets de bords.

L'ouverture du masque est également disposée pour que les deuxièmes électrodes 52 présentent toutes des deuxièmes branches 52b, s'étendant sensiblement perpendiculairement aux premières branches 52a. De la sorte, les électrodes finales 51, 52 pourront être connectées via une étape de reprise de contact.

La gravure des premières tranchées 821 est par exemple réalisée par plasma.

La figure 18 montre le dispositif obtenu après la formation des premières et deuxièmes tranchées 821, 822. Les deuxièmes tranchées 822 sont par exemple obtenue par retrait des premières électrodes 51. Ce retrait est réalisé de manière sélective par rapport aux espaceurs 71. Les espaceurs 71 sont ainsi libérés et présentent, de part et d'autre, des premières et deuxième tranchées 821, 822 dans lesquelles un matériau conducteur ou une structure de grille peut être déposé pour former les premières et deuxièmes électrodes 51, 52.

Le retrait des premières électrodes 51, ou plus particulièrement du premier matériau, peut être réalisé par une gravure anisotrope et sélective par rapport aux espaceurs 71. Il s'agit par exemple d'une gravure humide.

Lorsque les premières électrodes 51 sont séparées de la zone active 2 par un talon diélectrique, par exemple en oxyde, ce dernier peut également être retiré, par exemple par gravure au moyen d'acide fluorhydrique.

La formation des premières et deuxièmes électrodes 51, 52 est obtenue par remplissage des premières et deuxième tranchées 821, 822 par un matériau conducteur ou une structure de grille.

Dans le cas d'un matériau conducteur, ce dernier est par exemple déposé de manière à recouvrir les espaceurs 71, par exemple de manière conforme. Une planarisation par CMP avec arrêt sur le sommet des espaceurs 71 permet ainsi de former les premières et deuxièmes électrodes 51, 52 des figures 3 à 7 et 16.

Le matériau conducteur est par exemple du silicium polycristallin intrinsèquement dopé.

Par structure de grille, on entend une structure présentant une enveloppe extérieure conductrice, par exemple en tungstène, destinées à tapisser les parois de la cavité dans laquelle est formée la structure, et un matériau conducteur de remplissage, par exemple un nitrure de titane. Dans le cas où les premières et deuxièmes électrodes définitives 51, 52 présentent une structure de grille, un premier matériau conducteur pour former ladite enveloppe conductrice est déposé de manière conforme de manière à tapisser les premières et deuxièmes tranchées 821, 822.

Le matériau de remplissage est ensuite déposé de manière à recouvrir l'ensemble. Un planarisation par CMP avec arrêt au sommet des espaceurs 71 permet ainsi de former les électrodes définitives 51, 52.

Puisque les étapes précédentes de gravure et/ou de nettoyage à l'acide peuvent avoir endommagé l'oxyde de grille 22 de la zone active 2, il peut être préférable de former, dans un premier temps, un matériau diélectrique tapissant au moins le fond des premières et deuxièmes tranchées 821, 822 avant de former les électrodes 51, 52 dans ces tranchées 821, 822. Ainsi, la couche qubits 21 de la zone active 2 est protégée est isolée. Le matériau diélectrique est par exemple de l'oxyde de silicium. Le matériau diélectrique peut être formé par dépôt de couches atomiques dit « ALD » pour « Atomic Layer Deposition » en anglais. Il peut sinon être formé par oxydation du silicium de la couche qubits 21. Ledit matériau diélectrique présente une épaisseur d'environ 1 à 5 nm.

À la différence du premier mode de mise en œuvre précité, dans le deuxième mode de mise en œuvre pour former les deuxièmes électrodes 52, il n'y a que les premières tranchées 821 qui sont creusées, par exemple de la même façon que décrit précédemment. Les premières électrodes 51, lorsqu'elles sont formées par un matériau conducteur, ne sont pas retirées. Autrement dit, le dispositif intermédiaire de la figure 18 n'est pas obtenu.

La formation des deuxièmes électrodes 52 est alors obtenue par remplissage des premières tranchées 821 par un matériau conducteur ou une structure de grille.

Dans le cas d'un matériau conducteur, ce dernier est par exemple déposé de manière similaire au mode de mise en œuvre précédent. Lorsque les premières électrodes 51 sont formées dans un matériau conducteur, par exemple du silicium polycristallin intrinsèquement dopé, et que les premières tranchées 821 sont remplies avec le même matériau conducteur, toutes les deuxièmes électrodes 52 sont alors formées par le même matériau.

Alternativement, les premières tranchées 821 peuvent être remplies avec un matériau conducteur différent, offrant ainsi des premières et deuxièmes électrodes 51, 52 de deux types différents.

Idem lorsque les premières tranchées 821 sont remplies avec une structure de grille telle que décrite précédemment. Là aussi, les premières et deuxièmes électrodes 51, 52 sont de deux types différents.

Puisque la formation des premières tranchées 821 et/ou le nettoyage à l'acide de ces tranchées 821 peuvent avoir endommagé l'oxyde de grille 22 de la zone active 2, un oxyde de grille complémentaire peut être formé pour tapisser les premières tranchées 821, de la même manière qu'exposé précédemment (par exemple par ALD). Il en résulte que les deuxièmes électrodes 52 s'étendront sur une surépaisseur, dite « talon » ou « cale », s'étendant sur la couche qubit 21. L'épaisseur de ce talon peut être ajustée lors du dépôt du matériau diélectrique (par exemple entre 3 et 5 nm). Cette différence de hauteur (autrement dit, la présence d'un talon ou non) peut permettre de modifier le couplage avec la couche qubit 21 par rapport aux premières électrodes 51, de manière modifier la fonction de ces grilles. Une épaisseur différente et/ou un matériau du talon différent de celui de l'oxyde de grille permet d'ajuster la tension de seuil des électrodes 51, 52, 53.

La figure 19 présente le dispositif obtenu après formation des troisièmes électrodes définitives 53. Hormis la présence des contacts 9, ce dispositif correspond au circuit 1 des figures 3 à 7. Dans ce dispositif, les espaceurs 71 de la figure 16 sont remplacés par les troisièmes électrodes 53.

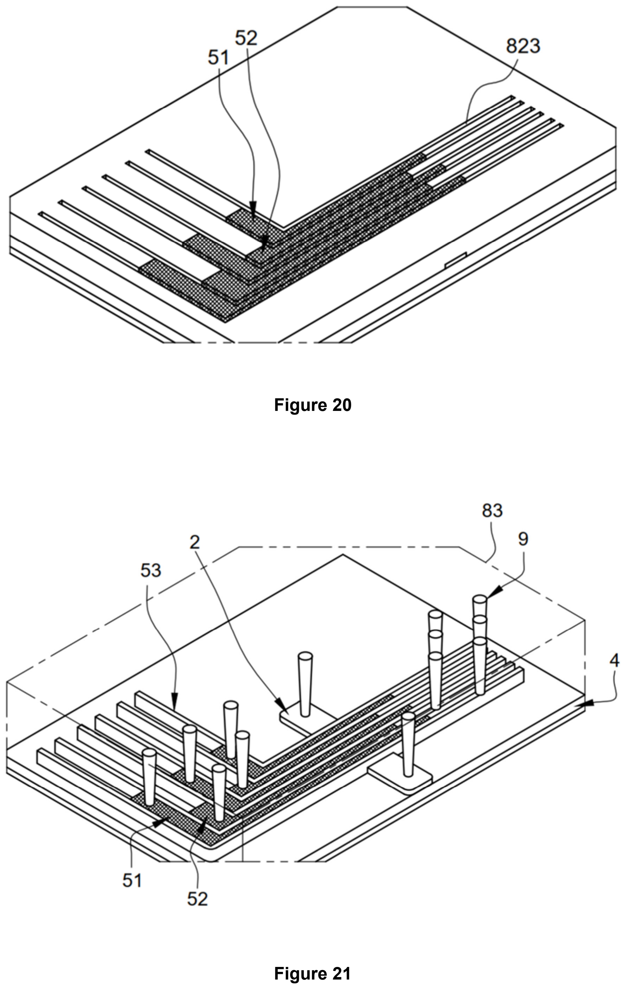

La figure 20 présente un dispositif dans lequel les espaceurs 71 ont été retirés. Ces derniers ont par exemple été gravés de manière sélective par rapport au premières et deuxièmes électrodes 51, 52. La gravure est par exemple réalisée de manière isotrope, par exemple par voie humide. Il s'agit par exemple de H₃PO₄ si les espaceurs 71 sont en nitrure de silicium. Le retrait des espaceurs 71 libère des troisièmes tranchées 823.

Lorsque les deuxièmes électrodes 52 sont formées en conservant les premières électrodes 51, les espaceurs 71 s'appuie donc directement contre ces premières électrodes 51 et en particulier contre le flanc 510 de ces électrodes. Ainsi, pour éviter le contact direct des troisièmes électrodes 53 avec ces flancs 510, il peut être nécessaire de former une couche isolante dans les troisième tranchées 823, tapissant ces dernières et tapissant notamment les flancs 510 des premières électrodes 51.

La couche isolante peut être déposée dans les troisièmes tranchées 823, par exemple par dépôt d'un matériau diélectrique par ALD. Elle peut aussi être formée thermiquement. Par exemple, lorsque les premières et/ou deuxièmes électrodes 51, 52 sont formées à partir d'un matériau conducteur non-métallique tel que le silicium polycristallin, un traitement thermique du dispositif de la figure 20 sous oxygène permet de former un film d'oxyde sur les flancs 510 des premières et deuxièmes électrodes 51, 52.

Les troisièmes électrodes 53 peuvent être formées par dépôt d'un matériau conducteur non-métallique, tel que du silicium polycristallin dopé. Ce dernier est par exemple déposé de manière conforme jusqu'à remplir complétement les troisièmes tranchées 823. Une planarisation par CMP avec arrêt au sommet des premières et/ou deuxièmes électrodes 51, 52 permet de former les troisièmes électrodes 53 de la figure 19.

Alternativement, les troisièmes électrodes 53 peuvent être formées par dépôt d'un matériau métallique, tel que du W. Une première couche en TiN est par exemple déposée de manière conforme dans les troisièmes tranchées 823 pour tapisser ces dernières. Elle s'étend préférentiellement sur la couche isolante s'étendant contre les premières et deuxièmes électrodes 51, 52. Une deuxième couche en W est ensuite déposée jusqu'à remplir complétement les troisièmes tranchées 823. Une planarisation par CMP avec arrêt au sommet des premières électrodes 31 permet enfin de former les deuxièmes électrodes 32.

L'insertion des troisièmes électrodes 53 entre les premières et deuxièmes électrodes 51, 52 permet de répartir les électrodes 51, 52, 53 avec un pas R/4. Ainsi, les électrodes 51, 52, 53 présentent, sur la zone active 2, un pas réduit.

La figure 21 présente le dispositif de la figure 19 qui est connecté à des contacts électriques 9 lors d'une étape de reprise de contact. La zone active 2 est également connectée.

Pour réaliser la reprise de contact, une encapsulation dans une troisième couche PMD 83 est réalisée. Des puits destinés à accueillir les contacts 9 sont ensuite réalisés par photolithographie DUV et gravure anisotrope, par exemple par plasma. Les puits sont par exemple localisés à la verticale des deuxièmes branches 51b, 52b des première et deuxièmes électrodes 51, 52 et à la verticale des premières branches 53a des troisièmes électrodes 53 (cas illustré par les figures 3, 4 et 21). Alternativement, les puits peuvent être localisés à la verticale des deuxièmes branches 53b des troisièmes électrodes 53 (cas illustré par la figure 7). Les contacts 9 sont par exemple formés par un dépôt de Ti/TiN suivi d'un remplissage de W afin de contacter l'ensemble des électrodes 51, 52, 53 fabriquées.

## Revendications

1. Circuit électronique (1) comprenant, sur un substrat :
- des premières électrodes de grilles (51) distantes les unes des autres, chaque première électrode de grille (51) présentant une première branche (51a) s'étendant parallèlement à une première direction (X), les premières branches (51a) des premières électrodes de grille étant réparties selon un pas constant R, mesuré selon une deuxième direction (Y) perpendiculaire à la première direction ;
- des deuxièmes électrodes de grille (52), chaque deuxième électrode de grille étant disposée entre deux premières électrodes de grille voisines, chaque deuxième électrode de grille (52) présentant une première branche (52a) s'étendant entre les deux premières branches (51a) des premières électrodes de grille (51) voisines,
le circuit électronique étant **caractérisé en ce qu'**il comprend des troisièmes électrodes de grille (53), chaque troisième électrode de grille (53) étant disposée entre une première électrode de grille (51) et une deuxième électrode de grille (52) voisines, chaque troisième électrode de grille (52) présentant une première branche (53a) s'étendant entre une première branche (51a) d'une première électrode de grille (51) et une première branche (52a) d'une deuxième électrode de grille (52), et **en ce que** les premières, deuxièmes et troisièmes électrodes de grilles (51, 52, 53) sont réparties selon un pas moyen, mesuré selon la deuxième direction (Y), égal à R/4, les premières, deuxièmes et troisièmes électrodes de grille (51, 52, 53) s'étendant au moins en partie sur une portion (2) du substrat (4), dite « zone active », configurée pour accueillir des boîtes quantiques, au moins deux électrodes de grille parmi les premières électrodes de grille ou au moins deux électrodes de grille parmi les deuxièmes électrodes de grille ou au moins deux électrodes de grille parmi les troisièmes électrodes de grille, présentent chacune un contact électrique indépendant l'un de l'autre.

2. Circuit électronique (1) selon la revendication 1, dans lequel les premières électrodes de grille (51) comprennent un premier matériau conducteur, les deuxièmes électrodes de grille (52) comprennent un deuxième matériau conducteur, identique au premier matériau conducteur, et les troisièmes électrodes de grilles (53) comprennent un troisième matériau conducteur, identique aux matériaux des premières et deuxièmes électrodes de grilles (51, 52).

3. Circuit électronique (1) selon l'une des revendications précédentes, dans lequel chaque troisième électrode de grille (53) présente une portion (53c, 53d), dite « portion libre », s'étendant au-delà des première et deuxième électrodes de grille (51, 52), le circuit électronique (1) comprenant des contacts électriques (9), chaque contact électrique étant connecté sur une portion libre (53c, 53d) d'une troisième électrode de grille (53) s'étendant au-delà des première et deuxième électrodes de grille (51, 52).

4. Circuit électronique (1) selon l'une des revendications précédentes, dans lequel chacune des premières, deuxièmes et troisièmes électrodes de grille (51, 52, 53) comprend une deuxième branche (51b, 52b, 53b) s'étendant perpendiculairement à sa première branche (51a, 52a, 53a).

5. Circuit électronique (1) selon l'une des revendications précédentes, dans lequel chacune des deuxièmes et troisièmes électrodes de grilles (52, 53) qui s'insèrent entre les premières électrodes de grille (51) présente une deuxième portion s'étendant selon la deuxième direction (Y).

6. Circuit électronique (1) selon l'une des revendications précédentes, dans lequel au moins deux électrodes de grille parmi les premières électrodes de grille (51) ou au moins deux électrodes de grille parmi les deuxièmes électrodes de grille (52) ou au moins deux électrodes de grille parmi les troisièmes électrodes de grille (53) sont indépendamment polarisées.

7. Circuit électronique (1) selon l'une des revendications précédentes, dans lequel la zone active (2) comprend une couche mince semiconductrice (21), destinée à recevoir les boîtes quantiques, et une couche isolante (22) s'étendant sur la couche mince semiconductrice (21) entre la couche mince semiconductrice (21) et les premières, deuxièmes et troisièmes électrodes de grilles (51, 52, 53).

8. Circuit électronique (1) selon l'une des revendications précédentes, dans lequel chacune des premières électrodes de grilles (51) présente un flanc (510), ledit flanc (510) étant une surface latérale délimitant ladite première électrode de grilles (51).

9. Circuit électronique (1) selon l'une des revendications précédentes, dans lequel les premières, deuxièmes et troisièmes électrodes de grilles (51, 52, 53) sont séparées les unes des autres par un film isolant (31).
